# EUROPEAN PATENT SPECIFICATION

(11) **EP 1 170 635 B1**
(45) Date of publication and mention of the grant of the patent: **07.06.2006**
(21) Application number: 01305740.1
(22) Date of filing: 03.07.2001
(51) Int. Cl.: G03F 7/20

(54) **Lithographic apparatus, device manufacturing method, and device manufactured thereby**
Lithographischer Apparat, Verfahren zur Herstellung eines Artikels und damit hergestellter Artikel
Appareil lithographique, méthode de fabrication d'un dispositif et dispositif fabriqué par cette méthode

(30) Priority: 05.07.2000 EP 00305666
(43) Date of publication of application: 09.01.2002
(73) Proprietor: ASML Netherlands B.V., 5504 DR Veldhoven (NL)
(72) Inventor: Krikke, Jan Jaap, 5682 HL Best (NL); Eurlings, Markus Franciscus Antonius, 4824 RK Breda (NL); Hoegee, Jan, 5653 LN Eindhoven (NL); Van der Veen, Paul, 5611 SR Eindhoven (NL)
(74) Representative: Leeming, John Gerard

(56) References cited:
- EP-A- 0 747 772
- EP-A- 1 186 956
- EP-B- 0 220 035
- ANONYMOUS: "Diaphragm at quartz-rod entrance for I-line scanners" RESEARCH DISCLOSURE, KENNETH MASON PUBLICATIONS, HAMPSHIRE, GB, vol. 423, no. 43, July 1999 (1999-07), XP007124577 ISSN: 0374-4353

## Description

The present invention relates to improvements to the illumination system in a lithographic projection apparatus comprising:
- a radiation system for providing a projection beam of radiation, said radiation system comprising an illumination system for adjusting angular and spatial energy distributions of said projection beam and for providing a preselected intensity distribution of said projection beam in a pupil of said illumination system;
- a support structure for supporting patterning means, the patterning means serving to pattern the projection beam according to a desired pattern;
- a substrate table for holding a substrate and being movable along *X* and *Y* directions in an *X, Y*-coordinate system defined in said apparatus;
- a projection system for projecting the patterned beam onto a target portion of the substrate, and for projecting said intensity distribution onto a pupil of the projection system.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular funtional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. An example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. The required matrix addressing can be performed using suitable electronic means. More information on such mirror arrays can be gleaned, for example, from US 5,296,891 and US 5,523,193. In the case of a programmable mirror array, the said support structure may be embodied as a frame or table, for example, which may be fixed or movable as required.
- A programmable LCD array. An example of such a construction is given in US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g*. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus - commonly referred to as a step-and-scan apparatus - each target portion is irradiated by progressively scanning the mask pattern under the projection beam in a given reference direction (the *Y* direction or "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Also herein, the invention is described using a reference system of orthogonal *X*, *Y* and *Z* directions. Further, unless the context otherwise requires, the term "vertical" used herein is intended to refer to the direction normal to the substrate or the plane comprising the pattern (as provided by the patterning means) or parallel to the optical axis of an optical system, rather than implying any particular orientation of the apparatus. Similarly, the term "horizontal" refers to a direction parallel to the substrate surface or the surface of a pattern, as generated by the patterning means, or perpendicular to the optical axis, and thus normal to the "vertical" direction. In particular, the horizontal direction corresponding with said scanning direction will be referred to as the *Y* direction.

Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Twin stage lithographic apparatus are described, for example, in US 5,969,441 and WO 98/40791.

Correct imaging of a pattern generated by a patterning means in a lithographic projection apparatus requires correct illumination of the patterning means; in particular it is important that the intensity of illumination proximal the plane of the pattern, as generated by the patterning means, or proximal planes conjugate to said plane of the pattern be uniform over the area of the exposure field. Also, it is generally required that the patterning means can be illuminated with off-axis illumination in a variety of modes. such as, for example, annular, quadrupole of dipole illumination, to improve resolution; for more information on the use of such illumination modes see, for example, EP 1 091 252.

Said illumination modes are, for example, obtained by providing a corresponding preselected intensity distribution in a pupil of the illumination system. To meet above-mentioned requirements, the illumination system of a lithographic projection system is generally quite complex. A typical illumination system might include: shutters and attenuators for controlling the intensity of the beam output by the source, which might be a high pressure Hg lamp or an excimer laser; a beam shaping element such as, for example, a beam expander for use with an excimer laser radiation beam to lower the radiation beam divergence; a zoomable axicon pair and a zoom lens for setting the illumination mode and parameters (collectively referred to as a zoom-axicon); an integrator, such as a quartz rod, for making the intensity distribution of the beam more uniform; masking blades for defining the illumination area; and imaging optics for projecting an image of the exit of the integrator onto the patterning means. For simplicity, the plane of the pattern generated by the patterning means, and planes conjugate to this plane in the radiation system and the projection system may be referred to hereinafter as "image" planes. The illumination system may also include elements intended to correct non-uniformities in the illumination beam at or near image planes. For instance the illumination system may include diffractive optical elements to improve the match of the projection beam cross-section proximal the entrance face of the integrator rod with the shape of said entrance face. A diffractive optical element typically consists of an array of microlenses, which may be Fresnel lenses or Fresnel zone plates. Improving said match alleviates the problem of field dependent lithographic errors occurring in the patterned layer. Said matching may hereinafter be referred to as "filling" of the integrator entrance face. A diffractive optical element may also be positioned, for example, in front of a beam shaping element, such as a zoom-axicon, to transform the angular distribution of radiation provided by an excimer laser beam into a preselected angular distribution of radiation for generating a desired illumination mode. For more information on illumination systems such as mentioned here, see for example EP 0747772 and US 5,675,401.

Also, the illumination system may, for instance, include a filter partially transmissive to radiation of the projection beam with a preselected spatial distribution of transmittance, immediately before the plane of the pattern, to reduce spatial intensity variations.

However, known illumination systems still suffer from various problems. In particular, various of the elements used, especially diffractive optical elements and quartz-rod integrators, can introduce an anomaly of intensity distribution in a plane perpendicular to the optical axis of the radiation system or the projection system. For instance, in a plane proximal a pupil of the radiation system or the projection system, either the projection beam cross-section may be elliptical rather than circular, or the projection beam intensity distribution within the projection beam cross-section may, for instance, be elliptically symmetric rather than circularly symmetric. Both types of errors are referred to as "ellipticity of the projection beam" or simply as "ellipticity error", and typically lead to specific lithographic errors in said patterned layers. In particular, a patterned feature occurring in directions parallel to both the *X* and *Y* direction may exhibit, in the presence of ellipticity of the projection beam, different sizes upon exposure and processing. Such a lithographic error is usually referred to as H-V difference. Also, a diffractive optical element used to improve filling of the integrator is generally only optimum for one setting of the zoom-axicon. For other settings, the integrator may be under-filled (the projection beam cross-section is smaller than the integrator entrance face), leading to substantial field dependent H-V difference. For said other settings, the integrator entrance face may also be over-filled, leading to energy wastage. Also, 157nm excimer lasers and other excimer lasers tend to have large divergence differences in *X* and *Y* directions which cannot be completely resolved using beam expander lenses whilst keeping the shape of the beam within acceptable dimensions.

It is an object of the present invention to provide an improved illumination system for use in a lithographic projection apparatus, and particularly an illumination system in which the ellipticity of the projection beam can be controlled or reduced and filling to the integrator entrance face can be controlled, to alleviate the problem of H-V difference.

This and other objects are achieved according to the invention in a lithographic apparatus and device manufacturing method as defined in the appended claims.

It is recognized in this invention that an optical element causing ellipticity of the projection beam may be rotated around the optical axis of the system comprising said optical element to counteract any ellipticity caused by another element traversed by the projection beam.

Ellipticity of the projection beam may, for instance, be corrected by a diffractive optical element provided in the illumination system. An illumination system may of course include more than one diffractive optical element. Dependant on the source and extent of the ellipticity in the projection beam, the diffractive optical element may be rotated to an appropriate angle to make use of any inherent ellipticity or may be manufactured with a specific degree of ellipticity, e.g. by making each microlens in an array asymmetric. Preferably the diffractive optical element completely removes ellipticity or reduces it to an acceptable level. The invention can thus provide a lithographic projection apparatus in which the rotational position of a diffractive optical element is orientated to counteract an ellipticity error.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "exposure area" or "target portion", respectively.

In the present document, the terms "radiation" and "beam" are used to encompass all types of electromagnetic radiation, including ultraviolet radiation (*e*.*g*. with a wavelength of 365, 248, 193, 157 or 126 nm) and EUV (extreme ultra-violet radiation, *e*.*g*. having a wavelength in the range 5-20 nm)

Embodiments of the invention will now be described, by way of example only, with reference to the accompanying schematic drawings in which:
Figure 1 depicts a lithographic projection apparatus according to a first embodiment of the invention;
Figure 2 is a more detailed view of the illumination system of the first embodiment of the invention;
Figures 3A and 3B are diagrams showing the effect of rotation of microlenses in a diffractive optical element; and
Figure 4 is a diagram showing a part of the illumination system in a second embodiment of the invention.

In the Figures, corresponding reference symbols indicate corresponding parts.

### Embodiment 1

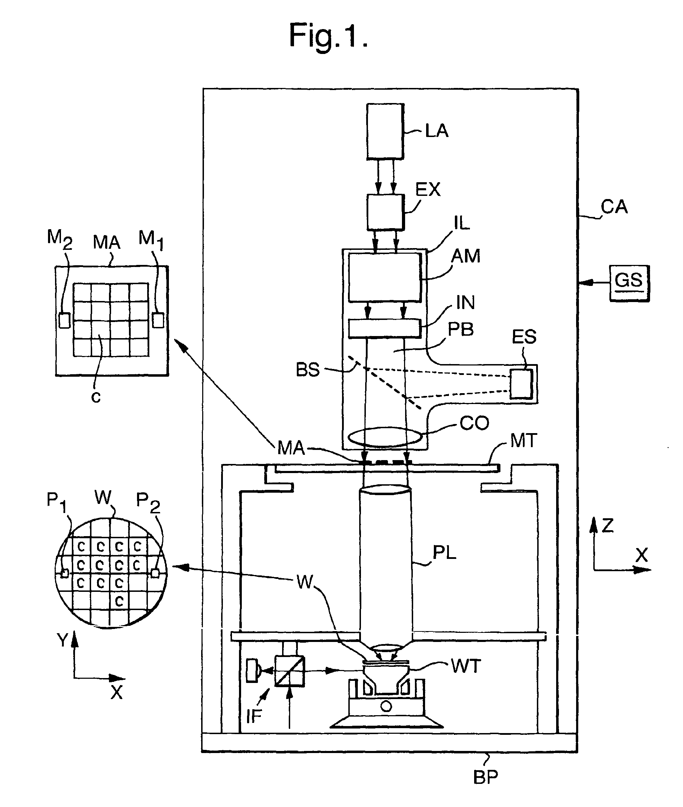

Figure 1 schematically depicts a lithographic projection apparatus according to a particular embodiment of the invention. The apparatus comprises:
· a radiation system Ex, IL, for supplying a projection beam PB of radiation (e.g. UV radiation). In this particular case, the radiation system also comprises a radiation source LA;
· a first object table (mask table) MT provided with a mask holder for holding a mask MA (e.g. a reticle), and connected to first positioning means for accurately positioning the mask with respect to item PL;
· a second object table (substrate table) WT provided with a substrate holder for holding a substrate W (e.g. a resist-coated silicon wafer), and connected to second positioning means for accurately positioning the substrate with respect to item PL;
· a projection system ("lens") PL (e.g. a quartz and/or CaF₂ lens system or a catadioptric system comprising lens elements made from such materials, or
a mirror system) for imaging an irradiated portion of the mask MA onto a target portion C (e.g. comprising one or more dies) of the substrate W.

As here depicted, the apparatus is of a transmissive type (i.e. has a transmissive mask). However, in general, it may also be of a reflective type, for example (with a reflective mask). Alternatively, the apparatus may employ another kind of patterning means, such as a programmable mirror array of a type as referred to above.

The source LA (e.g. a Hg lamp, an excimer laser, a laser or discharge plasma source or an undulator provided around the path of an electron beam in a storage ring or synchrotron which produces a beam of radiation) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. The settings of σ-outer and σ-inner (the "sigma settings") affect the angular distribution of the radiation energy delivered by said projection beam at, for instance, the substrate. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, e.g. so as to position different target portions C in the path of the beam PB. Similarly, the first positioning means can be used to accurately position the mask MA with respect to the path of the beam PB, e.g. after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (i.e. a single "flash") onto a target portion C. The substrate table WT is then shifted in the *X* and/or *Y* directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", e.g. the *Y* direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

In the illumination system IL, a part of the projection beam PB is diverted to an energy sensor ES by a beam splitter BS. Beam splitter BS may be a reflector formed by depositing aluminum on quartz and used to fold the projection beam to a convenient orientation. A pattern of small holes is etched into the aluminum layer so that only a known (relatively small) proportion of energy, e.g. 1%, is diverted to the energy sensor. The output of the energy sensor is used in controlling the dose delivered in an exposure.

Particularly in the case where radiation of wavelength 157 nm or below is used, the entire optical path of the apparatus is enclosed in one or more casings CA which can be flushed with a gas, e.g. dry N₂, transparent to the radiation used for the projection beam. The flushing, or purge, gas is supplied from gas supply GS which may be a container of clean gas or a plant for scrubbing and drying air, for example.

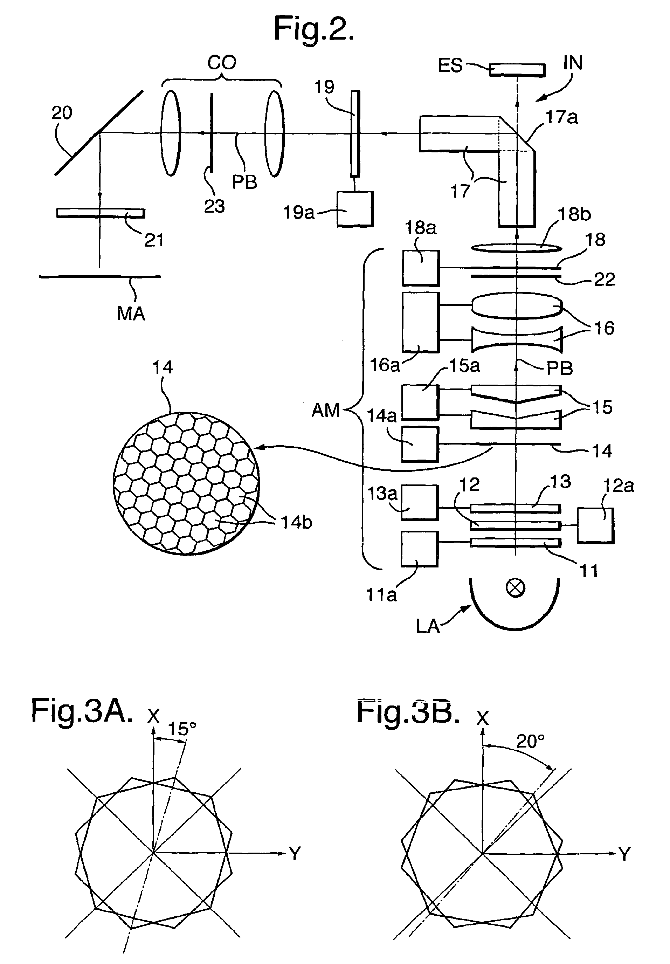

Figure 2 shows in greater detail the optical path of the projection beam from radiation source LA to mask MA. The radiation source LA in this embodiment is a highpressure Hg lamp provided with an elliptical reflector to collect the output radiation, but it may also be a laser. Two shutters are provided to control the output of the lamp: a safety shutter 11 held open by a coil 11 a and arranged to close automatically if any of the panels of the machine casing are opened; and a rotary shutter 12 driven by motor 12a for each exposure. A second rotary shutter 13 driven by motor 13a and having a light attenuating filter in the shutter aperture may be provided for low-dose exposures.

Beam shaping is principally performed by the axicon 15 and zoom lens 16, which are adjustable optical elements driven by respective servo systems 15a, 16a. These components are referred to collectively as the zoom-axicon. The axicon 15 includes a concave conical lens and complementary convex conical lens whose separation is adjustable. Setting the two elements of the axicon 15 together provides conventional circular illumination, whilst moving them apart creates an annular illumination distribution. The zoom lens 16 determines the size of the illumination beam or the outer radius of an annular illumination mode. Pupil shaping means (not shown) may be inserted, for instance, in the exit pupil 22 of the zoom-axicon module to provide quadrupole or other illumination modes.

A first diffractive optical element (DOE) 14 is provided to evenly fill the axicon 15. The diffractive optical element 14 comprises a closely packed array of (e.g. hexagonal) micro-lenses 14b, shown in the enlargement, which expand the beam and help define the pupil shape in, for instance, the pupil 22. Alternative forms of DOE include holographic DOEs, which use phase shifts to define a desired pupil shape and the desired energy distribution within the beam cross-section. The diffractive optical element may be one of a plurality of elements selectively interposable into the beam by exchanger 14a. Exchanger 14a may be arranged to adjust the position and orientation of the diffractive element in the beam PB.

The integrator IN in this case comprises two elongate quartz rods 17 joined at a right-angle prism 17a, the hypotenuse surface of which is partially silvered to allow a small, known proportion of the beam energy through to the energy sensor ES. The projection beam PB undergoes multiple internal reflections in the quartz rods 17 so that, looking back through it, there is seen a plurality of spaced apart virtual sources, thus evening out the intensity distribution of the projection beam. Note though that since the sides of the quartz rod are parallel to the optical axis, the limited illumination angles in annular, quadrupole or dipole illumination modes are preserved, as is the effective numerical aperture of the illumination system.

A second diffractive optical element 18 and coupling optics 18b are used to couple the light from the zoom-axicon into the quartz rod 17 and improve filling of it. The second diffractive optical element 18 may also be an array of suitably shaped (e.g. rectangular) micro-lenses or a hologram and may be adjustable or interchangeable under the control of exchanger 18a. Preferably, said second DOE 18 is located proximal a pupil such as, for example, pupil 22.

Close after the exit of the integrator IN are the reticle masking blades 19, which are used to define the illumination area, i.e. the area of the reticle to be illuminated. There are four separate reticle masking blades 19, which are individually driven by servo system 19a. The four blades are metal and have a wedge-shaped leading edge so as to direct stray light away from the reticle masking orifice.

The condensing optics CO form an objective lens for imaging the reticle masking orifice, via an intermediate pupil 23, on the reticle (mask). A folding mirror 20 is included for convenient location of the illumination system in the apparatus, and a gradient filter 21 is included to correct for known intensity variations.

Various of the optical elements in the illumination system can, in spite of all efforts to avoid this, introduce ellipticity errors into the projection beam PB. As explained above, ellipticity errors may cause, for instance, a lithographic error known as H-V difference. According to the invention, the first and/or second diffractive optical element 14, 18 is (are) rotatable and/or provided with a controlled ellipticity, as explained below, to compensate for ellipticity errors introduced by other elements in the optical system.

Figure 3A shows an intensity distribution in pupil 23, defining the shape of pupil 23, when using a conventional diffractive element 14 with hexagonal microlenses. This diffractive optical element comprises a hexagonal array of hexagonal microlenses each rotated 15° with respect to the *X* direction, about the optical axis, to provide a star-shaped pupil form with zero ellipticity. In principle, the intensity distribution in pupil 23 is a sum of two substantially uniform intensity distributions, each distribution being hexagonally shaped, and where, due to reflections in the integrator rod 17, one distribution is rotated 15° clockwise and the other distribution is rotated 15° counter clockwise with respect to the *X* direction. As a result the radial extents along the *X* and *Y* axes of the resulting intensity distribution are substantially equal, and hence no ellipticity error is introduced by DOE 14. However, as shown in Figure 3B, by rotating the whole diffractive optical element, the ellipticity of the pupil shape in pupil 23 can be changed. In Figure 3B, the angle of rotation with respect to the *X* axis of the diffractive optical element is increased by 5° with respect to the conventional 15° orientation defined above (so that it is rotated 20° with respect to the *X* direction), causing a noticeable ellipticity. Approximately 0.3-0.4% ellipticity offset is caused by a 1° increase of rotation of the diffractive optical element.

Accordingly therefore, the ellipticity errors caused by the illumination optical system as a whole and the diffractive optical element 14 are measured, and the diffractive optical element rotated to compensate. It is noted that whilst a rotation of the diffractive optical element by 90°, or a multiple of 90°, ought to have no effect on the magnitude of the ellipticity, in practice there can be a noticeable change in ellipticity. Such changes, known as apodisation, can be made use of in the present invention, which accordingly encompasses rotations of multiples of 90° as well as rotations of the order of a few degrees.

In variations of the first embodiment of the invention, the diffractive optical elements may be manufactured with non-regular hexagonal microlenses, stretched along one axis to introduce a predetermined ellipticity error to correct for ellipticity error caused by other elements.

Where the diffractive optical elements are hologram lenses, an ellipticity effect to correct for ellipticity error introduced by other elements can be deliberately introduced. The desired correction, and the necessary form of the hologram lens(es), can be calculated by computer. The hologram lens may, for example, generate an intensity distribution with circular shape and with an elliptically symmetric intensity anomaly to compensate for an ellipticity error caused by another element traversed by the projection beam.

In principle, it is often sufficient to only correct the so-called "dipole number". The dipole number represents the proportion of radiation energy in the quadrants along the *X* direction relative to the radiation energy in the quadrants along the *Y* direction, in a pupil plane. A value of 100% indicates equal energy in each set of quadrants. Optical elements introducing ellipticity error also affect said dipole number, and hence, can be used to correct said dipole number in accordance with the invention.

### Embodiment 2

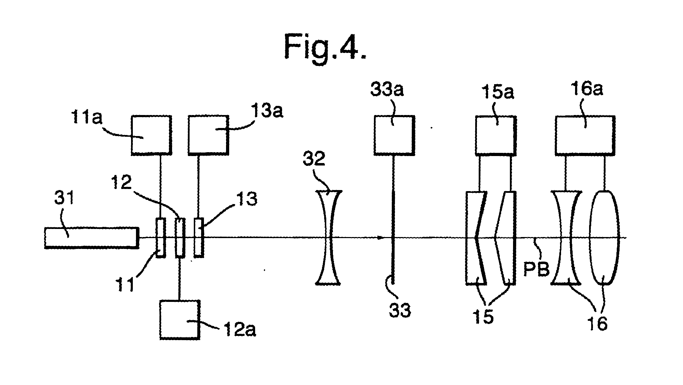

In a second embodiment of the invention, which may be the same as the first embodiment save as described below, a laser light source is used. Figure 4 shows the first few components of the illumination system of the second embodiment.

The laser 31 outputs a relatively narrow, collimated beam which passes through shutters 11, 12, 13 as in the first embodiment. It is then passed through beam divergence optics 32 which expand the beam to a convenient size, e.g. 30mm x 30mm in cross-section. Ideally, the beam expander 32 should output a collimated beam; however, at the edges of the beam there may be a divergence difference of up to 15 mrad between the *X* and *Y* directions (where the Z direction is the optical axis of the beam). In the second embodiment, the beam expanding optics are arranged to provide correct divergence in one direction, e.g. the Y direction, concentrating the divergence error in the other direction, e.g. the X direction, which is then corrected for by the diffractive optical element 33.

The diffractive optical element 33 is, for example, an array of positive hexagonal elements of width 0.25 mm and radius 2.6 mm, oriented at 15° with respect to the X axis, as shown in Figure 2 and 3A. This basic configuration is then modified to correct the divergence difference of the laser beam. The modification necessary to effect this will depend on the specific apparatus in which the invention is used and in particular the characteristics of the remainder of the illumination system. In one example of the second embodiment the X divergence can be corrected by reducing the width of the hexagonal microlenses in the X direction as follows:

| X-divergence (mrad) | X-size (mm) |
|---|---|
| 0 | 0.250 |
| 3 | 0.249 |
| 6 | 0.248 |
| 9 | 0.246 |
| 12 | 0.242 |

As in the first embodiment, in the second embodiment of the invention it may be sufficient only to correct the so-called dipole number. Changing the shape of the elements of the diffractive optical element 33 can affect the shape of the beam cross-section at the entrance to the zoom-axicon 15, 16 but such change is very small, even for large divergence values, and can be neglected.

The diffractive optical element 33 may be mounted on an exchanger 33a allowing different elements to be interposed in the beam for different effects, and allowing the orientation of such element to be adjusted so as to effect correction in accordance with the invention.

Whilst specific embodiments of the invention have been described above, it will be appreciated that the invention may be practiced otherwise than as described. The description is not intended to limit the invention.

## Claims

1. A lithographic projection apparatus comprising:
a radiation system for providing a projection beam of radiation, said radiation system comprising an illumination system (IL) for adjusting angular and spatial energy distributions of said projection beam and for providing a preselected intensity distributions of said projection beam in a pupil of said illumination system;
a support structure (MT) for supporting patterning means , the patterning means serving to pattern the projection beam according to a desired pattern;
a substrate table (WT) for holding a substrate and being movable along X and Y directions in an X, Y-coordinate system defined in said apparatus;
a projection system (PL) for projecting the patterned beam onto a target portion of the substrate, and for projecting said intensity distribution onto a pupil of the projection system, **characterized by** correction means (14, 14a) for correcting an intensity anomaly of said intensity distribution,
- wherein the intensity anomaly comprises two elongated sections distributed along said X and Y direction, respectively, having substantially different intensities, and
- wherein said correction means comprises an optical element (14) rotatable around the optical axis of said projection apparatus.

2. Apparatus according to claim 1 wherein said optical element is a diffractive optical element, operating either in transmission or reflection.

3. Apparatus according to claim 2 wherein said diffractive optical element (14) comprises an array of microlenses (14b).

4. Apparatus according to claim 3 wherein said array of microlenses (14b) is rotated such that a line joining centers of said microlenses is inclined to a reference direction perpendicular to the optical axis of said array at an angle in the range from 15.5° to 20°.

5. Apparatus according to claim 3 or 4, wherein each of said microlenses is not circularly symmetric in rotation about its center axis.

6. Apparatus according to claim 5 wherein each of said microlenses has a dimension in one of two orthogonal directions perpendicular to said optical axis in the range of from 94 to 99% of its dimension in the other orthogonal direction.

7. Apparatus according to any one of the preceding claims wherein said illumination system comprises an adjustable beam shaping element (15, 16) for defining said preselected intensity distribution and said optical element (33) is located before said adjustable beam shaping element.

8. Apparatus according to any one of the preceding claims wherein said radiation system comprises beam expanding means (32) for expanding a beam output by a laser and said optical element (33) is placed after said beam expanding means and is dimensioned for correcting differences in the angle of divergence of the beam in different directions.

9. An apparatus according to any of the claims 1 to 8, wherein the support structure comprises a mask table for holding a mask.

10. An apparatus according to any of the claims 1 to 8, wherein the radiation system comprises a radiation source.

11. A method of setting up a lithographic projection apparatus comprising:
a radiation system for providing a projection beam of radiation, said radiation system comprising an illumination system for adjusting angular and spatial energy distributions of said projection beam and for providing a preselected intensity distribution of said projection beam in a pupil of said illumination system; -
a support structure for supporting patterning means, the patterning means serving to pattern the projection beam according to a desired pattern; -
a substrate table for holding a substrate and being movable along *X* and *Y* directions in an *X,Y*-coordinate system defined in said apparatus;
a projection system for projecting the patterned beam onto a target portion of the substrate, and for projecting said intensity distribution onto a pupil of the projection system,
the method comprising the steps of providing correction means for correcting an intensity anomaly of said intensity distribution, wherein the intensity anomaly comprises two elongated sections distributed along said *X* and *Y* direction, respectively, having substantially different intensities, and adjusting the rotational position of at least one optical element, rotatable around the optical axis of said projection apparatus and comprised in said correction means, such that said anomaly is substantially compensated.

12. A device manufacturing method using a lithographic projection apparatus comprising the steps of:
providing a substrate that is at least partially covered by a layer of radiation-sensitive material;
providing a projection beam of radiation using a radiation system;
using a patterning means to endow the projection beam with a pattern in its cross-section;
projecting the patterned beam of radiation onto a target portion of the layer of radiation-sensitive material, **characterized by** the steps of:
providing correction means for correcting an intensity anomaly of an intensity distribution in a cross-section of the projection beam proximal a pupil selected from the group of pupils comprising a pupil of said radiation system and a pupil of said projection system, wherein the intensity anomaly comprises two elongated sections distributed along two mutually perpendicular directions, respectively having substantially different intensities, the rotational position of at least one optical element, rotatable around the optical axis of said projection apparatus and comprised in said correction means, being oriented such that said anomaly is substantially compensated.

## Patentansprüche

1. Lithografische Projektionsanordnung mit:
einer Strahlungsanordnung zum Bereitstellen eines Strahlungs-Projektionsstrahls, wobei die Strahlungsanordnung eine Beleuchtungsanordnung (IL) zum Einstellen von winkelmäßigen und räumlichen Energieverteilungen des Projektionsstrahls und zum Bereitstellen einer vorgewählten Intensitätsverteilung des Projektionsstrahls in einer Pupille der Beleuchtungsanordnung umfasst;
einer Haltestruktur (MT) zum Halten von mustererzeugenden Mitteln, wobei die mustererzeugenden Mittel dazu dienen, den Projektionsstrahl gemäß einem gewünschten Muster zu mustern;
einem Substrattisch (WT) zum Halten eines Substrats, der entlang X- und Y-Richtungen in einem X, Y-Koordinatensystem beweglich ist, das in der Vorrichtung definiert ist;
einer Projektionsanordnung (PL) zum Projizieren des gemusterten Strahls auf einen Zielabschnitt des Substrats und zum Projizieren der Intensitätsverteilung auf eine Pupille der Projektionsanordnung, **gekennzeichnet durch** Korrekturmittel (14, 14a) zum Korrigieren einer Intensitätsanomalie der Intensitätsverteilung,
- wobei die Intensitätsanomalie zwei längliche Abschnitte mit deutlich unterschiedlichen Intensitäten umfasst, die entlang der X- bzw. Y-Richtung verteilt sind, und
- wobei die Korrekturmittel ein optisches Bauteil (14) umfassen, das um die optische Achse der Projektionsanordnung drehbar ist.

2. Vorrichtung nach Anspruch 1, bei der das optische Bauteil ein beugendes optisches Bauteil ist, das entweder transmissiv oder reflektiv arbeitet.

3. Vorrichtung nach Anspruch 2, bei der das beugende optische Bauteil (14) eine Mikrolinsenmatrix (14b) umfasst.

4. Vorrichtung nach Anspruch 3, bei der die Mikrolinsenmatrix (14b) so gedreht ist, dass eine Mikrolinsenmittelpunkte verbindende Linie gegenüber einer Referenzrichtung senkrecht zur optischen Achse der Matrix in einem Winkel im Bereich von 15,5° bis 20° geneigt ist.

5. Vorrichtung nach Anspruch 3 oder 4, bei der jede Mikrolinse nicht kreisförmig rotationssymmetrisch um ihre Mittelachse ist.

6. Vorrichtung nach Anspruch 5, bei der jede der Mikrolinsen eine Ausdehnung in einer von zwei Orthogonalrichtungen senkrecht zu der optischen Achse im Bereich von 94 bis 99% ihrer Ausdehnung in der anderen Orthogonalrichtung hat.

7. Vorrichtung nach einem der vorhergehenden Ansprüche, bei der die Beleuchtungsvorrichtung ein einstellbares strahlformendes Bauteil (15, 16) zum Definieren der vorgewählten Intensitätsverteilung umfasst und das optische Bauteil (33) vor dem einstellbaren strahlformenden Bauteil angeordnet ist.

8. Vorrichtung nach einem der vorhergehenden Ansprüche, bei der die Strahlungsanordnung strahlweitende Mittel (32) zum Expandieren eines Strahlausgangs durch einen Laser umfasst und das optische Bauteil (33) nach dem strahlweitenden Mittel angeordnet ist und zum Korrigieren von Unterschieden des Divergenzwinkels des Strahls in verschiedenen Richtungen ausgelegt ist.

9. Vorrichtung nach einem der Ansprüche 1 bis 8, bei der die Haltestruktur einen Maskentisch zum Halten einer Maske umfasst.

10. Vorrichtung nach einem der Ansprüche 1 bis 8, bei der die Strahlungsanordnung eine Strahlungsquelle umfasst.

11. Verfahren zum Einrichten einer lithographischen Projektionsanordnung mit:
einer Strahlungsanordnung zum Bereitstellen eines Strahlungs-Projektionsstrahls, wobei die Strahlungsanordnung eine Beleuchtungsanordnung zum Einstellen von winkelmäßigen und räumlichen Energieverteilungen des Projektionsstrahls und zum Bereitstellen einer vorgewählten Intensitätsverteilung des Projektionsstrahls in einer Pupille der Beleuchtungsanordnung umfasst;
einer Haltestruktur zum Halten von mustererzeugenden Mitteln, wobei die mustererzeugenden Mittel dazu dienen, den Projektionsstrahl gemäß einem gewünschten Muster zu mustern;
einem Substrattisch zum Halten eines Substrats und der entlang X- und Y- Richtungen in einem X, Y-Koordinatensystem beweglich ist, das in der Vorrichtung definiert ist;
einer Projektionsanordnung zum Projizieren des gemusterten Strahls auf einen Zielabschnitt des Subtrats und zum Projizieren der Intensitätsverteilung auf eine Pupille der Projektionsanordnung,
wobei das Verfahren die Schritte des Bereitstellens von Korrekturmitteln zum Korrigieren einer Intensitätsanomalie der Intensitätsverteilung, wobei die Intensitätsanomalie zwei längliche Abschnitte mit deutlich unterschiedlichen Intensitäten aufweist, die entlang der X- bzw. Y- Richtung verteilt sind, und zum Einstellen der Rotationsstellung von mindestens einem optischen Bauteil umfasst, das um die optische Achse der Projektionsanordnung drehbar und in den Korrekturmitteln enthalten ist, so dass die Anomalie im Wesentlichen kompensiert wird.

12. Artikelherstellungsverfahren, das eine lithographische Projektionsanordnung verwendet, mit den Schritten:
Bereitstellen eines Substrats, das zumindest teilweise mit einer strahlungsempfindlichen Materialschicht bedeckt ist;
Bereitstellen eines Strahlungs-Projektionsstrahls unter Verwendung einer Strahlungsanordnung;
Verwenden von mustererzeugenden Mitteln zum Versehen des Projektionsstrahls mit einem Muster in seinem Querschnitt;
Projizieren des gemusterten Strahls auf einen Zielabschnitt der strahlungsempfindlichen Materialschicht, **gekennzeichnet durch** die Schritte:
Bereitstellen von Korrekturmitteln zum Korrigieren einer Intensitätsanomalie in einem Querschnitt des Projektionsstrahls nahe einer Pupille, die aus der Gruppe von Pupillen enthaltend eine Pupille der Strahlungsanordnung und eine Pupille der Projektionsanordnung ausgewählt ist, wobei die Intensitätsanomalie zwei längliche Abschnitte mit deutlich unterschiedlichen Intensitäten aufweist, die längs zweier zueinander rechtwinkligen Richtungen verteilt sind, wobei die Rotationsstellung von mindestens einem optischen Bauteil, das um die optische Achse der Projektionsanordnung drehbar und in den Korrekturmitteln enthalten ist, so orientiert ist, dass die Anomalie im Wesentlichen kompensiert wird.

## Revendications

1. Appareil de projection lithographique comportant :
un système de rayonnement pour fournir un faisceau de projection de rayonnement, ledit système de rayonnement comportant un système d'illumination (IL) pour ajuster des distributions d'énergie angulaires et spatiales dudit faisceau de projection et pour fournir des distributions d'intensité présélectionnées dudit faisceau de projection dans une pupille dudit système d'illumination ;
une structure de support (MT) pour supporter des moyens de mise en forme, les moyens de mise en forme servant à mettre en forme le faisceau de projection conformément à un motif voulu ;
une table de substrat (WT) pour supporter un substrat et qui est mobile le long de directions X et Y dans un système de coordonnées X,Y défini dans ledit appareil ;
un système de projection (PL) pour projeter le faisceau mis en forme sur une partie cible du substrat, et pour projeter ladite distribution d'intensité sur une pupille du système de projection, **caractérisé par** des moyens de correction (14, 14a) pour corriger une anomalie d'intensité de ladite distribution d'intensité,
- dans lequel l'anomalie d'intensité comporte deux sections allongées distribuées respectivement le long desdites directions X et Y, ayant des intensités sensiblement différentes, et
- dans lequel lesdits moyens de correction comportent un élément optique (14) pouvant tourner autour de l'axe optique dudit appareil de projection.

2. Appareil selon la revendication 1, dans lequel ledit élément optique est un élément optique de diffraction, fonctionnant en transmission ou réflexion.

3. Appareil selon la revendication 2, dans lequel ledit élément optique de diffraction (14) comporte un réseau de microlentilles (14b).

4. Appareil selon la revendication 3, dans lequel ledit réseau de microlentilles (14b) est tourné de sorte qu'une ligne reliant des centres desdites microlentilles est inclinée jusqu'à une direction de référence perpendiculaire à l'axe optique dudit réseau à un angle dans l'intervalle de 15,5° à 20°.

5. Appareil selon la revendication 3 ou 4, dans lequel chacune desdites microlentilles n'est pas circulairement symétrique en rotation autour de son axe central.

6. Appareil selon la revendication 5, dans lequel chacune desdites microlentilles a une dimension dans une de deux directions orthogonales perpendiculaires audit axe optique dans l'intervalle de 94 à 99 % de sa dimension dans l'autre direction orthogonale.

7. Appareil selon l'une quelconque des revendications précédentes, dans lequel ledit système d'illumination comporte un élément de formation de faisceau ajustable (15, 16) pour définir ladite distribution d'intensité présélectionnée et ledit élément optique (33) est situé avant ledit élément de formation de faisceau ajustable.

8. Appareil selon l'une quelconque des revendications précédentes, dans lequel ledit système de rayonnement comporte des moyens d'expansion de faisceau (32) pour expanser un faisceau émis par un laser et ledit élément optique (33) est placé après lesdits moyens d'expansion de faisceau et est dimensionné pour corriger des différences d'angle de divergence du faisceau dans différentes directions.

9. Appareil selon l'une quelconque des revendications 1 à 8, dans lequel la structure de support comporte une table de masque pour supporter un masque.

10. Appareil selon l'une quelconque des revendications 1 à 8, dans lequel le système de rayonnement comporte une source de rayonnement.

11. Procédé pour régler un appareil de projection lithographique comportant :
un système de rayonnement pour fournir un faisceau de projection de rayonnement, ledit système de rayonnement comportant un système d'illumination pour ajuster des distributions d'énergie angulaires et spatiales dudit faisceau de projection et pour fournir une distribution d'intensité présélectionnée dudit faisceau de projection dans une pupille dudit système d'illumination ;
une structure de support pour supporter des moyens de mise en forme, lesdits moyens de mise en forme servant à mettre en forme le faisceau de projection conformément à un motif voulu ;
une table de substrat pour supporter un substrat et qui est mobile le long de directions X et Y d'un système de coordonnées X,Y défini dans ledit appareil ;
un système de projection pour projeter le faisceau mis en forme sur une partie cible du substrat, et pour projeter ladite distribution d'intensité sur une pupille du système de projection,
le procédé comportant les étapes consistant à fournir des moyens de correction pour corriger une anomalie d'intensité de ladite distribution d'intensité, l'anomalie d'intensité comportant deux sections allongées distribuées respectivement le long desdites directions X et Y, ayant des intensités sensiblement différentes, et ajuster la position rotationnelle d'au moins un élément optique, pouvant tourner autour de l'axe optique dudit appareil de projection et inclus dans lesdits moyens de correction, de sorte que ladite anomalie est essentiellement compensée.

12. Procédé de fabrication d'un dispositif en utilisant un appareil de projection lithographique, comportant les étapes consistant à :
fournir un substrat qui est au moins partiellement recouvert d'une couche de matériau sensible au rayonnement ;
fournir un faisceau de projection de rayonnement en utilisant un système de rayonnement ;
utiliser des moyens de mise en forme pour doter le faisceau de projection d'un motif dans sa section transversale ;
projeter le faisceau de rayonnement mis en forme sur une partie cible de la couche de matériau sensible au rayonnement, **caractérisé par** les étapes consistant à :
fournir des moyens de correction pour corriger une anomalie d'intensité d'une distribution d'intensité dans une section transversale du faisceau de projection à proximité d'une pupille sélectionnée parmi le groupe de pupilles comportant une pupille dudit système de rayonnement et une pupille dudit système de projection, dans lequel l'anomalie d'intensité comporte deux sections allongées distribuées le long de deux directions mutuellement perpendiculaires, ayant respectivement des intensités sensiblement différentes, la position rotationnelle d'au moins un élément optique, pouvant tourner autour de l'axe optique dudit appareil de projection et inclus dans lesdits moyens de correction, étant orientée de sorte que ladite anomalie est essentiellement compensée.
